# EUROPEAN PATENT SPECIFICATION

(11) **EP 0 703 612 B1**
(45) Date of publication and mention of the grant of the patent: **25.11.1998**
(21) Application number: 94830442.3
(22) Date of filing: 20.09.1994
(51) Int. Cl.: H01L 23/367, H01L 23/00, H01L 23/433, H01L 23/373

(54) **Method for electrically insulating heat sinks in electronic power devices**
Methode zur elektrische Isolation von Kühlkörpern in elektronischen Leistungsschaltungen
Méthode pour isoler électriquement des dissipateurs de chaleur dans des dispositifs électroniques de puissance

(43) Date of publication of application: 27.03.1996
(73) Proprietor: STMicroelectronics S.r.l., 20041 Agrate Brianza (Milano) (IT)
(72) Inventor: Crema, Paolo, I-20044 Bernareggio (Prov. of Milan) (IT)
(74) Representative: Modiano, Guido, Dr.-Ing.

(56) References cited:
- DE-A- 2 900 114
- GB-A- 2 084 796
- PATENT ABSTRACTS OF JAPAN vol. 11, no. 23 (E-473) 22 January 1987 & JP-A-61 194 755 (HITACHI)
- PATENT ABSTRACTS OF JAPAN vol. 9, no. 216 (E-340) 3 September 1985 & JP-A-60 077 445 (TOSHIBA KK)
- PATENT ABSTRACTS OF JAPAN vol. 5, no. 15 (E-43) (687) 29 January 1981 & JP-A-55 143 054 (HITACHI SESAKUSHO K.K.)
- PATENT ABSTRACTS OF JAPAN vol. 9, no. 291 (E-359) 19 November 1985 & JP-A-60 132 350 (TOSHIBA KK)

## Description

The present invention relates to a method for electrically insulating heat sinks in electronic power devices.

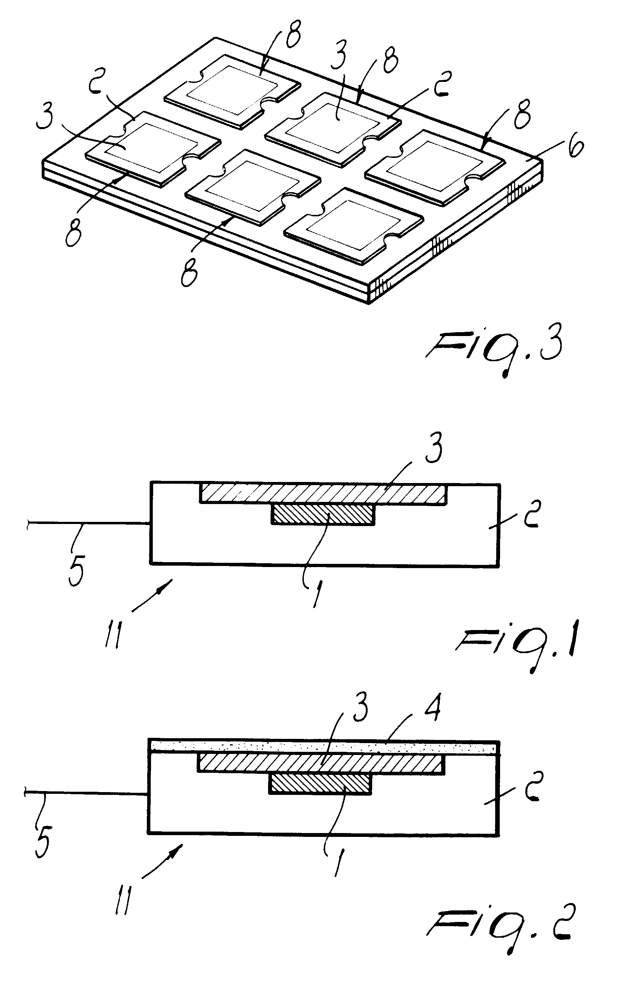

It is known that some electronic power devices that dissipate considerable heat are provided with heat sinks. With reference to figure 1, the power circuit is provided with an integrated chip 1 placed within a package 2 made of epoxy resin. The chip is connected by solder to a heat sink 3 which is advantageously made of a metal having high thermal conductivity, typically copper. One face of the heat sink 3 protrudes outside the electronic device so as to convey the flow of heat towards the surrounding air. The heat sink must have particular characteristics, namely high thermal conductivity and a large dissipation surface.

In some applications, such as for example high-fidelity audio devices, it is desirable to connect the heat sink to the external metal chassis of the device, so as to further increase the dissipation surface and accordingly improve heat dissipation. However, this arrangement has the drawback that the chassis of the device may have an electrostatic or other potential that can negatively affect the operation of the integrated chip. In some cases, the voltage between the chassis, the heat sink, and the integrated chip can irreversibly damage the chip of the power device.

Accordingly, it is necessary to electrically insulate the heat sink from the mechanical structures with which it is placed in contact. However, at the same time it is necessary to maintain the thermal conductivity of the device, i.e. its heat dissipation, at an optimum level.

A possible solution to this problem is to provide an insulating layer 4 (figure 2) on the heat sink 3 during the molding of the package 2 that contains the chip 1. This method for insulating the heat sink is not advisable, since it is difficult to ensure the thickness of the insulating layer. On one hand, if the insulating layer is too thick, the heat sink is unable to dissipate heat externally. On the other hand, if the thickness is insufficient, some regions of the heat sink may remain exposed.

Another possible solution uses a layer of oxidizing metal, typically aluminum, which is deposited on the heat sink and then oxidized. This method has the drawback that it makes the production process more complicated and has a high cost.

Another possible solution is to deposit an insulating layer by virtue of chemical treatments. This method is not advisable because chemical treatments are poorly selective and might contaminate the chip of the power device or cover the contacts 5 (figure 1) of the device.

From JP-A-61194755 is known an insulated semiconductor device whose mounting is facilitated by molding the header main surface side, to which a chip is fitted, with a resin and forming an insulating coating film on an exposed backside of the header.

From JP-A-60077445 is known a resin-sealed semiconductor device and a method for increasing the bonding strength of a heat sink plate by die mounting a semiconductor element at the prescribed position of a lead frame, removing part of the resin corresponding to the element to mount on the heat sink plate, securing the plate, then removing resin burrs generated at the periphery, and covering the plate with insulating coating film.

From JP-A-55143054 is known a resin sealed semiconductor device and a method for eliminating the need for insulating sheets wherein electrostatic coating of epoxy resin is applied to the flange of the heat sink plate, the flange having no sealing resin thereon.

From GB-A-2 084 796 is known a mounting and cooling arrangement for semiconductor devices.

Accordingly, a principal aim of the present invention is to provide a method for electrically insulating heat sinks in electronic power devices which can provide effective electrical insulation of the heat sink and preserve the desired thermal conductivity characteristics of the device.

Within the scope of this aim, an object of the present invention is to provide a method that uses existing technologies and equipment.

Another object of the present invention is to provide a method that increases as little as possible the complexity of the normal method for manufacturing the power device.

Another object of the present invention is to provide a method that is highly reliable, relatively easy to perform, and at competitive costs.

This aim, these objects, and others which will become apparent hereinafter are achieved by a method for electrically insulating heat sinks in electronic power devices as defined in claim 1. The characteristics and advantages of the invention will become apparent from the description of a preferred but not exclusive embodiment, illustrated only by way of non-limitative example in the accompanying drawings, wherein:
Figure 1 is a sectional view of an electronic power device without heat sink insulation;
Figure 2 is a sectional view of an electronic power device with heat sink insulation;
Figure 3 is a perspective view of the electronic power devices seated in the production mold;
Figure 4 is a sectional view of the power devices seated in the production mold and treated with the method according to the present invention;
Figure 5 is a sectional view of the package of the power device and of the mold, treated with the method according to the present invention;
Figure 6 is a sectional view of the package of the power device and of the mold, treated with the method according to the present invention;
Figure 7 is a sectional view of the power devices and of the mold, treated with an additional step of the method according to the present invention;
Figure 8 is a view of the structure obtained with the method according to the present invention;
Figure 9 is a sectional view of the power devices seated in the mold and treated with another embodiment of the method according to the present invention.

With reference to the above figures, the power devices are closed in a mold 6 so that an upper part 8, which comprises the face of the heat sink, protrudes above the outer wall of the mold, as shown in figure 3.

The lamination step, in which the mold 6 and the power devices 11 are inserted in a laminating machine, is then performed. Said machine is commonly used to deposit an insulating layer of epoxy resin on printed circuit boards. This resin is commonly termed "solder mask". The laminating machine usually comprises two rollers on which two layers of material are rolled: the first layer 9 is the layer of epoxy resin, and the second layer 10 is a backing layer made of polyester.

The mold 6, together with the devices 11, is made to advance inside the laminating machine and is subjected exclusively to the action of the upper roller, i.e. the roller that faces the protruding parts 8 of the power devices. The two layers 9 and 10 are deposited in a heated atmosphere, so as to facilitate contact between the epoxy resin 9, which is still in the gel state, the mold 6, and the power devices 11.

The entire system is then cooled so as to stop the movement of the gel that constitutes the layer 9 of epoxy resin.

Once the gel 9 has cooled, the backing layer 10 is peeled off so as to leave the gel layer 9 exposed.

Since the gel layer is spread over the entire work area (the mold 6 and the devices 11), it is necessary to selectively remove the layer of resin 9 from the parts that cover the mold 6.

In order to do this, a mask 12, provided with openings that allow the passage of ultraviolet rays only on the regions of the resin 9 that cover the power devices 11, is applied. These regions are accordingly exposed to UV rays 13 (figure 7) so as to cure or polymerize them. In this manner, these regions cannot be removed with chemical treatments.

In order to remove the resin 9 placed on the mold 6, a chemical treatment with a saline solution of sodium carbonate Na₂CO₃ is performed, etching the regions that have not been exposed and cured by the UV rays 13.

In this manner one obtains the structure as shown in figure 8, wherein the insulating layer 9 is left only on the devices 11.

The insulating layer 9 (epoxy resin) is still not mechanically strong, that is to say, it can still be scratched and damaged mechanically.

In order to obviate this, a further curing or polymerization with UV rays 13 is performed.

Finally, heat curing in an oven is performed for 8 hours at 170°C, further polymerizing both the insulating layer 9 and the package 2 of the power device 11.

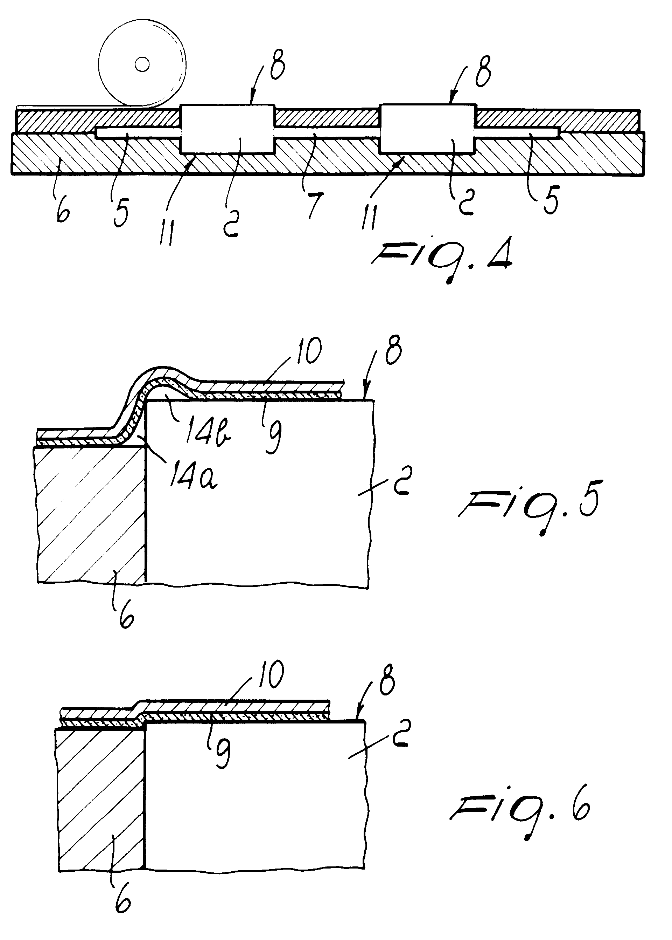

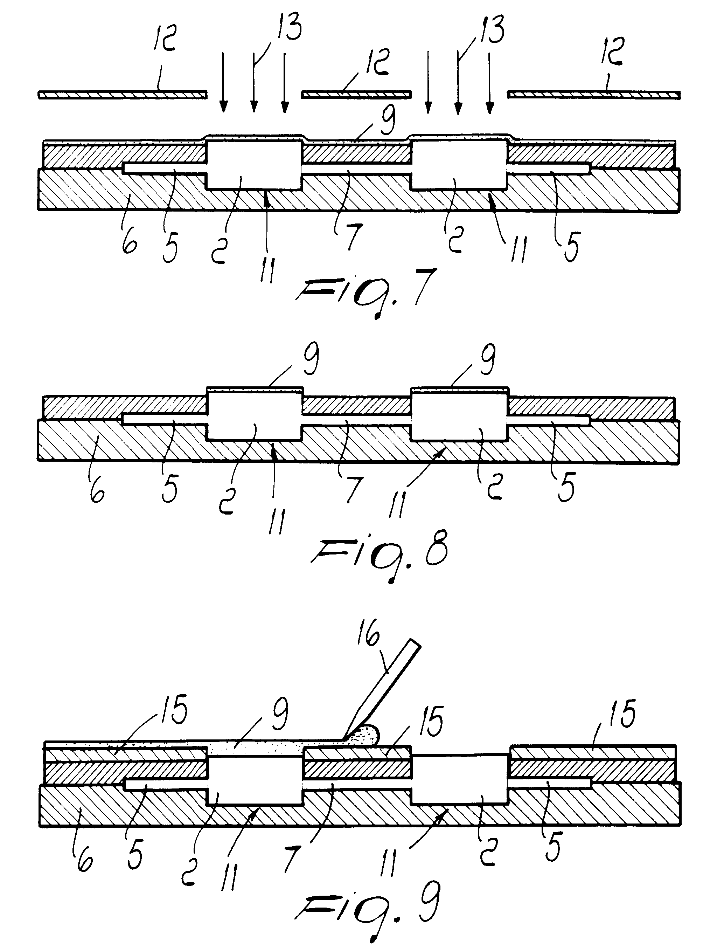

In order to achieve better results, it is important that the protruding part 8 of the package 2 protrude only by an extent that is equal to, or smaller than, the thickness of the layer of resin 9 as shown in figure 6. If instead the protruding part 8 protrudes by more than that extent, as in the case of figure 5, air pockets 14a and 14b form. This effect is undesirable, since after the removal of the unwanted regions of the insulating layer 9 it leaves exposed surfaces on the device 11 and on the heat sink 3.

It is important to note that the rolls of epoxy resin 9, in the dry state, are supplied by the supplier in guaranteed thicknesses. In this way it is possible to have a uniform thickness of for example 25 or 50 µm. It is furthermore not necessary to produce special rolls or special machines, since they are already available for the production of printed circuit boards.

Another advantage is that the invention uses the existing step for the heat curing of the package 2 of the device to cure the insulating layer 9.

A second embodiment of the present invention spreads, by means of a doctor blade 16, gelatinous (liquid) resin 9 through a screen-printing frame 15. The thickness of the frame 15 must meet the thickness requirements of the insulating layer that forms above the devices 11.

This step is followed by UV-ray curing and by heat curing as in the previous case.

In this case, the thickness of the insulating layer is controlled by the thickness of the screen-printing frame and by the density of the resin in the liquid state.

It has been observed that the present invention fully achieves the intended aim and objects. In particular, a film of dry resin with a thickness of 50 µm insulates the heat sink from a 1000-V voltage with a loss of 5 nA. The junction-package heat resistance Rₜₕ has been found to be on the order of 1.3-1.4, which fully meets the required characteristics. The insulated devices have furthermore been kept inside a pressure cooker for over two hours and at a temperature of 100^{o}C; after this treatment the insulation did not show peeling. Likewise, the devices were subjected to dry etching with a temperature of 175°C for eight hours, and the devices were immersed from the terminal end in solder for 10 seconds and at the temperature of 240^{o}C so as to make contact with the package over 2 mm. The insulation did not separate in these last two cases either.

The invention thus conceived is susceptible of numerous modifications and variations, all of which are within the scope of the inventive concept.

Thus, for example, it is possible to use other materials for the insulating layer, such as nylon, mylar, acrylic resins, or different materials that compose the solder mask, such as acrylic materials and polyimide.

The insulating layer can furthermore be applied with other methods, such as for example electrochemically, chemically, by vacuum, by gluing, and so forth.

In particular, the forming step of the insulating layer may comprise the step of gluing the insulating layer to the face of the power device and to the wall of the mold.

All the details may furthermore be replaced with other technically equivalent ones.

In practice, the materials employed, as well as the shapes and dimensions, may be any according to the requirements without thereby abandoning the scope of the protection of the appended claims.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A method for electrically insulating the heat sink in an electronic power device, the electronic power device (11) comprising a device package (2) made of epoxy resin, and a heat sink (3) embedded in said epoxy resin, said heat sink being exposed on one face of said power device, an insulating layer being formed on the face of said electronic device, characterized in that the insulating layer forming step comprises:
- inserting at least one electronic device (11) in a mold (6) so that said one face (8) protrudes above a wall of said mold;
- forming an insulating layer made of solder mask (9,10) on said face of the power device (11) and on said wall of the mold (6);
- curing the regions of said insulating layer (9,10) which are arranged above said electronic device (11); and
- removing the uncured regions.

2. A method according to claim 1, characterized in that said solder mask is dry epoxy resin.

3. A method according to claim 1, characterized in that the step of forming an insulating layer is a lamination step carried out by means of at least one roller adapted to deposit said insulating layer on said face and on said wall of the mold.

4. A method according to claim 1, characterized in that said curing step comprises a step for polymerization by exposure to ultraviolet rays.

5. A method according to claim 1, characterized in that said removing step includes the step of removal by chemical etching.

6. A method according to claim 1, characterized in that it comprises a second curing step.

7. method according to claim 6, characterized in that said second curing step includes a step for polymerization by means of ultraviolet rays and a heat curing step.

8. A method according to claim 1, characterized in that said heat curing step is the same step used for the heat curing of the package of said electronic device.

9. A method according to claim 1, characterized in that said face protrudes by an extent at the maximum equal to the thickness of the insulating layer.

10. A method according to claim 1, characterized in that said laminating is carried out by means of a laminating machine for producing printed circuits.

11. A method according to claim 1, characterized in that said solder mask is rolled up on said roller.

12. A method according to claim 1, characterized in that said insulating layer is formed by spreading it through a screen printing frame.

13. A method according to claim 12, characterized in that said insulating layer is liquid epoxy resin.

14. a method according to claim 12, characterized in that said insulating layer is composed of at least one of the following materials: nylon, mylar, acrylic resin, and polyimide.

15. A method according to claim 1, characterized in that the forming step of said insulating layer comprises the step of gluing said insulating layer to the face of the power device and to the wall of the mold.

## Patentansprüche

1. Verfahren zum elektrischen Isolieren eines Wärmeableitmittels in einer elektronischen Leistungseinrichtung, wobei die elektronische Leistungseinrichtung (11) ein Bauelementgehäuse (2), das aus einem Epoxidharz hergestellt ist, und ein Wärmeableitmittel (3) aufweist, das in dem Epoxidharz eingebettet ist, wobei das Wärmeableitmittel auf einer Fläche der Leistungseinrichtung freiliegt und wobei eine Isolierschicht auf der Fläche der elektronischen Einrichtung gebildet wird,
**dadurch gekennzeichnet,** daß der Schritt des Bildens der Isolierschicht enthält:
Einbringen von zumindest einer elektronischen Einrichtung (11) in eine Form (6), so daß diese eine Fläche (8) über eine Wand der Form hervorsteht,
Erzeugen einer aus einer Lötabdeckung (9, 10) hergestellten Isolierschicht auf dieser Fläche der Leistungseinrichtung (11) und auf dieser Wand der Form (6),
Aushärten der Bereiche der Isolierschicht (9, 10), die über der elektronischen Einrichtung (11) angeordnet sind, und
Entfernen der nicht ausgehärteten Bereiche.

2. Verfahren nach Anspruch 1,
**dadurch gekennzeichnet**, daß die Lötabdeckung trockenes Epoxidharz ist.

3. Verfahren nach Anspruch 1,
**dadurch gekennzeichnet**, daß der Schritt des Bildens einer Isolierschicht ein Laminierschritt ist, der mittels zumindest einer Walze ausgeführt wird, die zur Ablagerung der Isolierschicht auf der Fläche und auf der Wand der Form in der Lage ist.

4. Verfahren nach Anspruch 1,
**dadurch gekennzeichnet**, daß der Aushärtschritt aus einem Schritt der Polymerisation durch Bestrahlen mit ultravioletten Strahlen besteht.

5. Verfahren nach Anspruch 1,
**dadurch gekennzeichnet**, daß der Schritt des Entfernens ein Entfernen durch chemisches Ätzen enthält.

6. Verfahren nach Anspruch 1,
**dadurch gekennzeichnet**, daß das Verfahren einen zweiten Aushärtschritt enthält.

7. Verfahren nach Anspruch 6,
**dadurch gekennzeichnet**, daß der zweite Aushärtschritt einen Schritt der Polymerisation mittels ultravioletter Strahlen und einen Wärmeaushärtschritt enthält.

8. Verfahren nach Anspruch 1,
**dadurch gekennzeichnet**, daß der Wärmeaushärtschritt der gleiche Schritt ist, der für die Wärmeaushärtung des Gehäuses der elektronischen Einrichtung verwendet wird.

9. Verfahren nach Anspruch 1,
**dadurch gekennzeichnet**, daß die Fläche in einem Maß übersteht, das maximal gleich der Dicke der Isolierschicht ist.

10. Verfahren nach Anspruch 1
**dadurch gekennzeichnet**, daß das Laminieren mittels einer Laminiermaschine zum Herstellen von gedruckten Schaltungen ausgeführt wird.

11. Verfahren nach Anspruch 1,
**dadurch gekennzeichnet**, daß die Lötabdeckung auf der Walze aufgerollt ist.

12. Verfahren nach Anspruch 1,
**dadurch gekennzeichnet**, daß die Isolierschicht durch Verteilen mittels eines Siebdruckrahmens gebildet wird.

13. Verfahren nach Anspruch 12,
**dadurch gekennzeichnet**, daß die Isolierschicht ein flüssiges Epoxidharz ist.

14. Verfahren nach Anspruch 12,
**dadurch gekennzeichnet**, daß die Isolierschicht aus zumindest einem der folgenden Materialien gebildet ist; Nylon, Mylar, Acrylharz und Polyimid.

15. Verfahren nach Anspruch 1,
**dadurch gekennzeichnet**, daß der Schritt des Bildens der Isolierschicht den Schritt des Aufklebens der Isolierschicht auf die Fläche der Leistungseinrichtung und auf der Wand der Form enthält.

## Revendications

1. Procédé pour isoler électriquement le radiateur d'un dispositif électronique de puissance, le dispositif électronique de puissance (11) comprenant un boîtier (2) en résine époxy et un radiateur (3) logé dans la résine époxy, le radiateur étant exposé sur une face du dispositif de puissance, une couche isolante étant formée sur la face du dispositif électronique, caractérisé en ce que la formation de la couche isolante comprend les étapes suivantes :
- insérer au moins un dispositif électronique (11) dans un moule (6) de sorte que ladite face (8) fasse saillie au-dessus d'une paroi du moule ;
- former une couche isolante en un masque de soudure (9, 10) sur la face du dispositif de puissance (11) et sur la paroi du moule (6) ;
- recuire les régions de la couche isolante (9, 10) qui sont disposées au-dessus du dispositif électronique (11) ; et
- enlever les régions non cuites.

2. Procédé selon la revendication 1, caractérisé en ce que le masque de soudure est une résine époxy sèche.

3. Procédé selon la revendication 1, caractérisé en ce que l'étape de formation d'une couche isolante est une étape de stratification effectuée au moyen d'au moins un rouleau adapté à déposer la couche isolante sur ladite face et sur la paroi du moule.

4. Procédé selon la revendication 1, caractérisé en ce que l'étape de cuisson comprend une étape de polymérisation par exposition aux rayons ultraviolets.

5. Procédé selon la revendication 1, caractérisé en ce que l'étape d'enlèvement inclut l'étape d'enlèvement par gravure chimique.

6. Procédé selon la revendication 1, caractérisé en ce qu'il comprend une seconde étape de cuisson.

7. Procédé selon la revendication 6, caractérisé en ce que la seconde étape de cuisson comprend une étape de polymérisation par des rayons ultraviolets et une étape de cuisson thermique.

8. Procédé selon la revendication 1, caractérisé en ce que l'étape de cuisson thermique est la même étape que celle utilisée pour la cuisson thermique du boîtier du dispositif électronique.

9. Procédé selon la revendication 1, caractérisé en ce que ladite face fait saillie d'une quantité au plus égale à l'épaisseur de la couche isolante.

10. Procédé selon la revendication 1, caractérisé en ce que la stratification est effectuée par une machine à stratifier destinée à produire des circuits imprimés.

11. Procédé selon la revendication 1, caractérisé en ce que le masque de soudure est déposé au rouleau.

12. Procédé selon la revendication 1, caractérisé dans la couche isolante est formée en l'étalant à travers un cadre de sérigraphie.

13. Procédé selon la revendication 12, caractérisé en ce que la couche isolante est une résine époxy liquide.

14. Procédé selon la revendication 12, caractérisé en ce que la couche isolante est constituée d'au moins l'un des matériaux suivants : Nylon, Mylar, résine acrylique et polyimide.

15. Procédé selon la revendication 1, caractérisé en ce que l'étape de formation de la couche isolante comprend l'étape de collage de la couche isolante sur la face du dispositif de puissance et sur la paroi du moule.
